# EUROPEAN PATENT SPECIFICATION

(11) **EP 1 636 274 B1**
(45) Date of publication and mention of the grant of the patent: **12.08.2009**
(21) Application number: 04748684.0
(22) Date of filing: 25.06.2004
(51) Int. Cl.: C08F 2/46, C09D 175/16

(54) **PHOTOCURABLE RESIN COMPOSITION**
PHOTOHÄRTBARE HARZZUSAMMENSETZUNG
COMPOSITION DE RESINE PHOTODURCISSABLE

(30) Priority: 26.06.2003 JP 2003182094
(43) Date of publication of application: 22.03.2006
(73) Proprietor: DSM IP Assets B.V., 6411 TE Heerlen (NL); JSR Japan Synthetic Rubber Co., Ltd., Tokyo 104-8410 (JP); Japan Fine Coatings Co., Ltd., Ibaraki, 300-4104 (JP)
(72) Inventor: YASHIRO, Takao, Tokyo 104-8410 (JP); TATARA, Ryoji, Ibaraki 305-0044 (JP); TANABE, Takayoshi, Ibaraki 305-0045 (JP)
(74) Representative: Hatzmann, Martin
(86) International application number: PCT/NL2004/000454
(87) International publication number: WO 2004/113395

(56) References cited:
- EP-A- 0 360 869
- EP-A- 0 938 026
- WO-A-03/076528

## Description

### Field of the Invention

The present invention relates to a curable resin composition exhibiting high photocurability and producing a cured product with excellent mechanical and thermal strength. More particularly, the present invention relates to a curable resin composition useful as a resin composition used for three-dimensional photofabrication for manufacturing a cured product (fabricated product) for which high initial strength, small amount of warping, bending resistance, and fracture toughness are required.

### Prior Art

In recent years, a three-dimensional photofabrication method is proposed, wherein a step of selectively applying light to a photocurable substance (resin composition) to form a cured resin layer is repeatedly performed to form a three-dimensional product in which the cured resin layers are integrally stacked (see for example Japanese Patent Application Laid-open No. 60-247515). A typical example of the three-dimensional photofabrication method is described below.

A cured resin layer having a specific pattern is formed by selectively applying light from a UV laser or the like to the surface of a photocurable resin composition placed in a vessel. The photocurable resin composition for one layer is supplied onto the cured resin layer. Light is selectively applied to the surface to form another cured resin layer on the previously formed cured resin layer so that the cured resin layers are integrally and continuously stacked. The above step is repeatedly performed a specific number of times while changing the exposure pattern or without changing the exposure pattern to obtain a three-dimensional product in which the cured resin layers are integrally stacked. This three-dimensional photofabrication method has attracted attention, since a three-dimensional product can be easily formed in a short period of time even if the shape of the desired three-dimensional product is complicated.

Many photocurable resin compositions suitable for the photofabrication of three dimensional objects are known in the art. These resin compositions may be liquid, gel-like or paste like. They can contain fillers like for example silica, mica, talcum, and many other fillers known in the art. Examples of liquid photocurable resin composition used for the three-dimensional photofabrication method are the following resin compositions (a) to (c):
(a) A resin composition comprising a radically polymerizable organic compound such as urethane (meth)acrylate, oligoester (meth)acrylate, epoxy (meth)acrylate, thiol compound, ene compound, or photosensitive polyimide (see for example Japanese Patent Application Laid-open No. 1-204915).
(b) A resin composition comprising a cationically polymerizable organic compound such as an epoxy compound, cyclic ether compound, cyclic lactone compound, cyclic acetal compound, cyclic thioether compound, spiroorthoester compound, and vinyl ether compound (see for example Japanese Patent Application Laid-open No. 1-213304).
(c) A resin composition comprising a radically polymerizable organic compound and a cationically polymerizable organic compound (see for example Japanese Patent Application Laid-open No. 2-28261; Japanese Patent Application Laid-open No. 2-75618; Japanese Patent Application Laid-open No. 6-228413; Japanese Patent Application Laid-open No. 11-310626; Japanese Patent Application Laid-open No. 11-228610; Japanese Patent Application Laid-open No. 11-240939).

A three-dimensional product obtained by using the three-dimensional fabrication method is commonly used as a shape confirmation model for examining the design. However, a recent market trend tends to require such a three-dimensional product to have properties equivalent to general-purpose engineering plastics used as a mounting material, such as a thermoplastic resin. This aims at reducing the development period and cost of products by using a three-dimensional product obtained by using a photocurable resin not only for shape confirmation, but also for evaluation tests for the mounting material, such as an assembling test, drop test, heat resistance test, or durability test. In order to apply a three-dimensional product to such evaluation tests, a cured resin must have the same characteristics as the mounting material.

It is very difficult to obtain high fabrication accuracy by using the composition (a) due to large cure shrinkage. High fabrication accuracy can be obtained by using the composition (b). However, the resulting cured product tends to exhibit low toughness and brittleness. Moreover, initial strength (green strength) after photocuring and the cure speed are inferior in comparison with the case of using the composition (a), whereby a high fabrication speed cannot be achieved. The composition (c) achieves high fabrication accuracy and excellent mechanical properties by compensating for the drawbacks of the above two methods. However, some of the mechanical and thermal characteristics are inferior in comparison with a general-purpose resin. In particular, fracture toughness is lower than that of a general-purpose resin.

### Problems to be Solved by the Invention

An object of the present invention is to provide a photocurable resin composition excelling in photocurability and capable of producing a cured product having excellent bending resistance and fracture toughness while maintaining high fabrication accuracy and heat resistance.

### Means for Solving the Problems

The present inventors have conducted extensive studies in order to achieve the above object. As a result, the present inventors have found that a cured product of a composition comprising a (meth)acryloyl compound having a polymerizable carbon-carbon double bond in an isocyanurate structure excels in bending resistance and fracture toughness and has high photocurability, fabrication accuracy, and heat resistance.

Specifically, the present invention provides a photocurable resin composition comprising:
(A) 30-85 wt% of a cationically polymerizable component,
(B) 0.1-10 wt% of a cationic-polymerization initiator,
(C) 5-45 wt% of a component having a structure shown by the following formula (1), 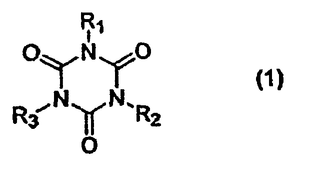 wherein R¹, R², and R³ individually represent organic groups, provided that at least two of R¹, R², and R³ have a polymerizable carbon-carbon double bond,
(D) 0.1-10 wt% of a radical-polymerization initiator, and
(E) 0-20 wt% of a component having at least one radically polymerizable group in the molecule, and wherein component A is selected from the group consisting of 3,4-epoxycyclohexylmethyl-3',4'-epoxycyclohexanecarboxylate, bis(3,4-epoxycyclohexylmethyl)adipate, ε-caprolactone-modified 3,4-epoxycyclohexylmethyl-3',4'-epoxycyclohexanecarboxylate, trimethylcaprolactone-modified 3,4-epoxycyclohexylmethyl-3',4'-epoxycyclohexanecarboxylate, β-methyl-δ-valerolactone-modified 3,4-epoxycyclohexylmethyl-3',4'-epoxycyclohexanecarboxylate, bisphenol A diglycidyl ether, bisphenol F diglycidyl ether, hydrogenated bisphenol A diglycidyl ether, hydrogenated bisphenol F diglycidyl ether, 1,4-butanediol diglycidyl ether, 1,6-hexanediol diglycidyl ether, trimethylolpropane triglycidyl ether, glycerol triglycidyl ether, polyethylene glycol diglycidyl ether and polypropylene glycol diglycidyl ether.

### Preferred Embodiment of the Invention

The cationically polymerizable component (A) used in the present invention is a component which undergoes polymerization or crosslinking through a cationic polymerization reaction, initiated for example by applying light to the component in the presence of a cationic photoinitiator. Examples of the cationically polymerizable component (A) used in the present invention are an epoxy compound, oxetane compound, oxorane compound, cyclic acetal compound, cyclic lactone compound, thiirane compound, thiethane compound, spiroorthoester compound and vinyl ether compound.

Suitable epoxy compounds which can be used as component (A) are generally known in the art and are 3,4-epoxycyclohexylmethyl-3',4'-epoxycyclohexanecarboxylate, bis(3,4-epoxycyclohexylmethyl)adipate, ε-caprolactone-modified 3,4-epoxycyclohexylmethyl-3',4'-epoxycyclohexanecarboxylate, trimethylcaprolactone-modified 3,4-epoxycyclohexylmethyl-3',4'-epoxycyclohexanecarboxylate, β-methyl-δ-valerolactone-modified 3,4-epoxycyclohexylmethyl-3',4'-epoxycyclohexanecarboxylate, bisphenol A diglycidyl ether, bisphenol F diglycidyl ether, hydrogenated bisphenol A diglycidyl ether, hydrogenated bisphenol F diglycidyl ether, 1,4-butanediol diglycidyl ether, 1,6-hexanediol diglycidyl ether, trimethylolpropane triglycidyl ether, glycerol triglycidyl ether, polyethylene glycol diglycidyl ether and polypropylene glycol diglycidyl ether.

As other cationically polymerizable organic compounds that can be used as the component (A), oxetane such as trimethylene oxide, 3,3-dimethyloxetane, 3,3-dichloromethyloxetane, 3-ethyl-3-phenoxymethyloxetane, and bis(3-ethyl-3-methyloxy)butane; oxolane such as tetrahydrofuran and 2,3-dimethyltetrahydrofuran; cyclic acetal such as trioxane, 1,3-dioxolane, and 1,3,6-trioxanecyclooctane; cyclic lactone such as γ-propyolactone and ε-caprolactone; thiirane such as ethylene sulfide, 1,2-propylene sulfide, and thioepichlorohydrin; thiethane such as 3,3-dimethylthietane; vinyl ether such as ethylene glycol divinyl ether, triethylene glycol divinyl ether, and trimethylolpropane trivinyl ether; ethylenically unsaturated compounds such as vinylcyclohexane, isobutylene, and polybutadiene; derivative of these compounds; and the like can be given.

It is preferable that the component (A) contains 50 wt% or more of epoxy compounds in order to maintain high cure speed and good mechanical strength.

As commercially available products of cationically polymerizable compounds suitably used as the component (A), UVR-61 00, UVR-6105, UVR-6110, UVR-6128, UVR-6200, UVR-6216 (manufactured by Union Carbide Corp.), Celoxide 2021, Celoxide 2021 P, Celoxide 2081, Celoxide 2083, Celoxide 2085, Epolead GT-300, Epolead GT-301, Epolead GT-302, Epolead GT-400, Epolead 401, Epolead 403 (manufactured by Daicel Chemical Industries, Ltd.), KRM-2100, KRM-2110, KRM-2199, KRM-2400, KRM-2410, KRM-2408, KRM-2490, KRM-2200, KRM-2720, KRM-2750 (manufactured by Asahi Denka Kogyo Co., Ltd.), Rapicure DVE-3, CHVE, PEPC (manufactured by ISP), Epikote 828, Epikote 812, Epikote 1031, Epikote 872, Epikote CT 508 (manufactured by Japan Epoxy Resins Co., Ltd.), XDO (manufactured by Toagosei Co., Ltd.), VECOMER 2010, 2020, 4010, 4020 (manufactured by AlliedSignal), and the like can be given. The cationically polymerizable compound may be included in the component (A) either individually or in combination of two or more.

The component (A) may be used in the composition of the present invention in an amount of for examples 30-85 wt%, preferably 30-80 wt%, and still more preferably 40-75 wt%. The presence of component (A) in the above amounts has the advantage of generating photofabricated products showing minimal deformation such as warping, sufficient mechanical and good thermal characteristics.

The cationic-polymerization initiator (B) used in the present invention is a compound which generates a substance that initiates cationic polymerization of the component (A) when energy rays such as light are applied. The energy rays such as light used herein refer to visible light, ultraviolet light, infrared light, X-rays, α-rays, β-rays, γ-rays, and the like. As examples of a particularly preferable compound used as the component (B), an onium salt having a structure of the following formula (2) can be given.

[R⁴ₐR⁵_{b}R⁶R⁷_{d}W] + p[MX_{p+q}]^{-q} (2)

wherein the cation is an onium ion; W is S, Se, Te, P, As, Sb, Bi, O, I, Br, Cl, or -N□N; R⁴, R⁵, R⁶, and R⁷ are the same or different organic groups; a, b, c, and d are individually integers from 0 to 3, provided that (a + b + c + d) is equal to the valence of W. M is a metal or a metalloid which constitutes the center atom of the halide complex [MX_{p+q}]. For example, M is B, P, As, Sb, Fe, Sn, Bi, Al, Ca, In, Ti, Zn, Sc, V, Cr, Mn, Co, or the like. X is a halogen atom such as F, Cl, or Br, q is a positive charge of a halide complex ion; and p is the valence of M. The onium salt generates a Lewis acid upon exposure to light. As specific examples of the anion [MX_{p+q}] in the formula (2), tetrafluoroborate (BF₄⁻), hexafluorophosphate (PF₆⁻), hexafluoroantimonate (SbF₆⁻), hexafluoroarsenate (AsF₆⁻), hexachloroantimonate (SbCl₆⁻), and the like can be given.

Onium salts having an anion shown by [MXₚ(OH)⁻] may be used. In addition, onium salts having other anions such as a perchloric acid ion (ClO₄⁻), trifluoromethanesulfonic acid ion (CF₃SO₃⁻), fluorosulfonic acid ion (FSO₃⁻), toluenesulfonic acid ion, trinitrobenzenesulfonic acid anion, and trinitrotoluenesulfonic acid anion can also be used.

Of these, aromatic onium salts are preferable as the component (B).
The above cationic photopolymerization initiator may be included in the component (B) either individually or in combination of two or more.

The component (B) may be used in the photocurable resin composition of the present invention in an amount of usually 0.1-10 wt%, preferably 0.2-5 wt%, and still more preferably 0.3-3 wt%. The presence of the component (B) in the above amounts results in excellent photocurability of the resulting resin composition, whereby a three-dimensional product exhibiting sufficient mechanical strength is fabricated.

The component (C) used in the photocurable resin composition of the present invention has a structure shown by the following formula (1). 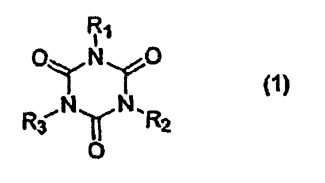 wherein R¹. R², and R³ individually represent organic groups, provided that at least two of R¹, R², and R³ have a polymerizable carbon-carbon double bond.

The component(C) contributes to a reduction of cure shrinkage and an increase in fabrication accuracy in comparison with other polyfunctional acryloyl compounds due to conformation originating in the heterocyclic structure of the formula (1). Moreover, the component(C) improves heat resistance and provides high toughness to the resulting cured product.

R¹, R², and R³ in the component(C) are individually organic groups.
At least two of R¹, R², and R³ are organic groups having a polymerizable carbon-carbon double bond. The component (C) undergoes a polymerization or crosslinking reaction by irradiation in the presence of the component (D) (radical-polymerization initiator) due to the polymerizable carbon-carbon double bond. As the polymerizable carbon-carbon double bond, ethylenically unsaturated groups such as an (meth)acryloyl group, a (meth)allyl group, and a vinyl group can be given.

In the component (C), a spacer molecule may be introduced between the carbon-carbon double bond and the isocyanurate cyclic structure. An example of a suitable spacer molecule is an aliphatic chain by modifying the isocyanurate cyclic structure with for example ethylene oxide, propylene oxide, or ε-caprolactone.

As specific examples of the component (C) which can be used in the present invention, bis((meth)(acryloxymethyl)hydroxymethyl isocyanurate, bis((meth)acryloxyethyl)hydroxyethyl isocyanurate, tris((meth)acryloxymethyl)isocyanurate, tris((meth)acryloxyethyl)isocyanurate, caprolactone-modified tris((meth)acryloxyethyl)isocyanurate, and the like can be given. Of these, bis((meth)acryloxyethyl)hydroxyethyl isocyanurate and tris((meth)acryloxyethyl)isocyanurate are particularly preferable.

As commercially available products which can be suitably used as the component (C), M-215, M-315, M-325 (manufactured by Toagosei Co., Ltd.), TEICA (manufactured by Daiichi Kogyo Seiyaku Co., Ltd.), TAIC, TMAIC (manufactured by Nippon Kasei Chemical Co., Ltd.), and the like can be given. The above compounds may be included in the component (C) either individually or in combination of two or more.

The component (C) can be used in an mount of usually 5-45 wt%, preferably 7-40 wt%, and still more preferably 10-35 wt%. The presence of the component(C) in the above amounts results in photofabricated products having sufficient mechanical properties such as fracture toughness and high initial strength. Also the cure shrinkage is minimal, whereby dimensional accuracy of the resulting photofabricated product is excellent and no deformation with time will occur.

The radical-polymerization initiator (D) is a compound which decomposes upon exposure to energy rays such as light, and generates a radical to initiate a radical polymerization reaction of the components (C) and (E).

Examples of the radical-polymerization initiator which can be used as the component (D) are acetophenone, acetophenone benzyl ketal, anthraquinone, 1-(4-isopropylphenyl)-2-hydroxy-2-methylpropan-1-one, carbazole, xanthone, 4-chlorobenzophenone, 4,4'-diaminobenzophenone, 1,1-dimethoxydeoxybenzoin, 3,3'-dimethyl-4-methoxybenzophenone, thioxanethone compounds, 2-methyl-1-[4-(methylthio)phenyl]-2-morpholino-propan-2-one, 2-benzyl-2-dimethylamino-1-(4-morpholinophenyl)-butan-1-one, triphenylamine, 2,4,6-trimethylbenzoyldiphenylphosphine oxide, bis(2,6-dimethoxybenzoyl-2,4,4-trimethylpentylphosphine oxide, benzyl dimethyl ketal, 1-hydroxycyclohexylphenyl ketone, 2-hydroxy-2-methyl-1-phenylpropan-1-one, fluorenone, fluorene, benzaldehyde, benzoin ethyl ether, benzoin propyl ether, benzophenone, Michler's ketone, 3-methylacetophenone, 3,3',4,4'-tetra(t-butylperoxycarbonyl)benzophenone (BTTB), combinations of BTTB and dyesensitizers such as xanthene, thioxanthene, cumarin, and ketocumarin. Particular preferable radical polymerization initiators are benzyl dimethyl ketal, 1-hydroxycyclohexylphenyl ketone, 2,4,6-trimethylbenzoyldiphenylphosphine oxide and 2-benzyl-2-dimethylamino-1 -(4-morpholinophenyl)-butan-1-one. The radical-polymerization initiator may be included in the component (F) either individually or in combination of two or more.

The component (D) is used in the photocurable resin composition of the present invention in an amount of usually 0.01-10 wt%, and preferably 0.1-8 wt%.

The photocurable resin composition of the present invention may further include a photosensitizer (polymerization accelerator), a reactive diluent, and the like. As examples of the photosensitizers, amine compounds such as triethanolamine, methyldiethanolamine, triethylamine, and diethylamine, thioxanethone, derivatives of thioxanethone, anthraquinone, derivatives of anthraquinone, anthracene, derivatives of anthracene, perylene, derivatives of perylene, benzophenone, benzoin isopropyl ether, and the like can be given.

The photocurable resin composition of the present invention may further include (E) a compound having at least one radically polymerizable group in the molecule. Preferably the component (E) is a compound having an ethylenically unsaturated bond (C=C) in the molecule. Examples of the component (E) are monofunctional monomers having one ethylenically unsaturated bond in one molecule and polyfunctional monomers having two or more ethylenically unsaturated bonds in one molecule can be given.

Examples of the monofunctional monomers are for example isobornyl , (meth)acrylate, lauryl (meth)acrylate, and phenoxyethyl (meth)acrylate.

Examples of polyfunctional monomers that can be suitably used as the component (E) are ethylene glycol di(meth)acrylate, dicyclopentenyl di(meth)acrylate, triethylene glycol diacrylate, tetraethylene glycol di(meth)acrylate, tricyclodecanediyldimethylene di(meth)acrylate, trimethylolpropane tri(meth)acrylate, ethylene oxide (hereinafter may be abbreviated as "EO") modified trimethylolpropane tri(meth)acrylate, propylene oxide (hereinafter may be abbreviated as "PO") modified trimethylolpropane tri(meth)acrylate, tripropylene glycol di(meth)acrylate, neopentyl glycol di(meth)acrylate, both terminal (meth)acrylate adduct of bisphenol A diglycidyl ether, 1,4-butanediol di(meth)acrylate, 1,6-hexanediol di(meth)acrylate, pentaerythritol tri(meth)acrylate, pentaerythritol tetra(meth)acrylate, polyester di(meth)acrylate, polyethylene glycol di(meth)acrylate, dipentaerythritol hexa(meth)acrylate, dipentaerythritol penta(meth)acrylate, dipentaerythritol tetra(meth)acrylate, caprolactone-modffied dipentaerythritol hexa(meth)acrylate, caprolactone-modified dipentaerythritol penta(meth)acrylate, ditrimethylolpropane tetra(meth)acrylate, EO-modified bisphenol A di(meth)acrylate, PO-modified bisphenol A di(meth)acrylate, EO-modified hydrogenated bisphenol A di(meth)acrylate, PO-modified hydrogenated bisphenol A di(meth)acrylate, EO-modified bisphenol F di(meth)acrylate and (meth)acrylate of phenol novolak polyglycidyl ether.

The monofunctional and polyfunctional monomers may be included in the component (E) either individually or in combination of two or more, or in combination of at least one monofunctional monomer and at least one polyfunctional monomer. It is preferable that the component (E) includes a polyfunctional monomer having three or more ethylenically unsaturated bonds (trifunctional or more) in one molecule in an amount of 60 wt% or more. The amount of the polyfunctional monomer having three or more ethylenically unsaturated bonds is still more preferably 70 wt% or more, particularly preferably 80 wt% or more, and most preferably 100 wt%. If the amount of the polyfunctional monomer having three or more ethylenically unsaturated bonds is 60 wt% or more, photocurability of the resulting resin composition is improved and the resulting three-dimensional product rarely exhibits deformation with time.

The polyfunctional monomers having three or more ethylenically unsaturated bonds may be selected from the above tri(meth)acrylate compounds, tetra(meth)acrylate compounds, penta(meth)acrylate compounds, and hexa(meth)acrylate compounds. Of these, trimethylolpropane tri(meth)acrylate, EO-modified trimethylolpropane tri(meth)acrylate, dipentaerythritol hexa(meth)acrylate, dipentaerythritol penta(meth)acrylate, and ditrimethylolpropane tetra(meth)acrylate are particularly preferable.

The component (E) may be used in the photocurable resin composition of the present invention in an amount of for example 0-20 wt%, and preferably 0-10 wt% of the total amount of the composition.

The amount of the component (C) relative to the amount of the components (C) and (E) is usually 50 wt% or more, preferably 60 wt% or more, still more preferably 70 wt% or more, and particularly preferably 100 wt%. These relative amounts of the component (C) to the total amount of the components (C) and (E) gives a sufficient improvement effect of fracture toughness and heat resistance.

The photocurable resin composition of the present invention may include (F) elastomer particles with an average particle diameter of 10-1000 nm. Impact resistance and fracture toughness of the cured product obtained by applying light to the composition of the present invention can be further increased by adding the component (F). Specific examples of the component (F) are elastomer particles containing polybutadiene, polyisoprene, butadiene/acrylonitrile copolymer, styrene/butadiene copolymer, styrene/isoprene copolymer, ethylene/propylene copolymer, ethylene/α-olefin copolymer, ethyliene/α-olefin/polyene copolymer, acrylic rubber, butadiene/(meth)acrylate copolymer, styrene/butadiene block copolymer, or styrene/isoprene block copolymer as the basic component.

Moreover, core-shell type particles produced by coating these elastomer particles with a methyl methacrylate polymer, methyl methacrylate/glycidyl methacrylate copolymer, or the like can also be given as examples. The ratio of the core radius to the shell thickness is usually from 1/2 to 1000/1, and preferably from 1/1 to 200/1 (for example, if the core radius is 350 nm and the shell thickness is 10 nm, the ratio is 35/1).

In the case of core/shell type particles, among the above-mentioned elastomer particles, elastomer particles in which a partially crosslinked core of polybutadiene, polyisoprene, styrene/butadiene copolymer, styrene/isoprene copolymer, butadiene/(meth)acrylate copolymer, styrene/butadiene block copolymer, and styrene/isoprene block copolymer is coated with methyl methacrylate polymer, methyl methacrylate/glycidyl methacrylate copolymer are particularly preferable.

In addition, elastomer particles may have a crosslinking structure.
The crosslinking structure may be introduced by known conventional methods. Examples of crosslinking agents used in such a method are divinylbenzene, ethylene glycol di(meth)acrylate, diallylmaleate, triallylcyanurate, triallylisocyanurate, diallylphthalate, trimethylolpropane triacrylate and allyl methacrylate.

Examples of commercially available products of these core-shell type elastomer particles are Reginous Bond RKB (manufactured by Reginous Chemical Industries Co., Ltd.), Techno MBS-61, MBS-69 (manufactured by Techno Polymer Co., Ltd.). The elastomer particles (F) may be used either individually or in combination of two or more.

The component (F) may be used in the photocurable resin composition of the present invention in an amount of usually 1-35 wt%, more preferably 3-30 wt%, and particularly more preferably 5-20 wt%. These amounts of component (F) result in photofabricated products having further improved impact resistance and fracture toughness.

The photocurable resin composition of the present invention may include (G) a polyether polyol having three or more hydroxyl groups in one molecule. Mechanical properties, in particular the modulus of elasticity, of the cured product obtained by applying light to the composition of the present invention can be increased by adding the component (G). The component (G) is added in order to increase photocurability of the resin composition and to improve form stability (suppressing deformation with time) and physical stability (suppressing change in mechanical characteristics with time) of the three-dimensional product obtained by photofabrication. The polyether polyol used as the component (G) preferably has three or more, and preferably 3-6 hydroxyl groups in one molecule.

Examples of the component (G) are polyether polyols obtained by modifying polyhydric alcohols having three or more hydroxyl groups such as trimethylolpropane, glycerol, pentaerythritol, sorbitol, sucrose, and quadrol with cyclic ether compounds such as ethylene oxide (EO), propylene oxide (PO), butylene oxide, and tetrahydrofuran. Specific examples include EO-modified trimethylolpropane, PO-modified trimethylolpropane, tetrahydrofuran-modified trimethylolpropane, EO-modified glycerol, PO-modified glycerol, tetrahydrofuran-modified glycerol, EO-modified pentaerythritol, PO-modified pentaerythritol, tetrahydrofuran-modified pentaerythritol, EO-modified sorbitol, PO-modified sorbitol, EO-modified sucrose, PO-modified sucrose, EO-modified sucrose, EO-modified quadrol and the like. Of these, EO-modified trimethylolpropane, PO-modified trimethylolpropane, PO-modified glycerol, PO-modified sorbitol are preferable.

The molecular weight of the polyether polyol used as the component (G) can be preferably 100-2,000, and still more preferably 160-1,000. These molecular weights of the polyether polyol used as the component (G) may further improve the form stability and physical stability.

The polyether polyol may be included in the component (G) either individually or in combination of two or more.

The component (G) may be used in the photocurable resin composition of the present invention in an amount of for example 1-35 wt%, preferably 5-30 wt%, and particularly preferably 7-25 wt%.

Various other components may be added to the composition as long as formation of the three dimensional object and the properties of the object or resin composition are not adversely effected.

Various additives may be added to the photocurable resin composition for photofabrication of the present invention as other optional components insofar as the objects and effects of the present invention are not impaired. Examples of such additives include polymers or oligomers such as epoxy resin, polyamide, polyamideimide, polyurethane, polybutadiene, polychloroprene, polyether, polyester, styrene-butadiene block copolymer, petroleum resin, xylene resin, ketone resin, cellulose resin, fluorine-containing oligomer, silicone-containing oligomer, and polysulfide oligomer, polymerization inhibitors such as phenothiazine and 2,6-di-t-butyl-4-methylphenol, polymerization initiation adjuvant, leveling agents, wettability improvers, surfactants, plasticizers, UV absorbers, silane coupling agents, inorganic fillers, pigments, dyes, and the like. The photocurable resin composition of the present invention can be produced by homogeneously mixing the components (A)-(I) and, if required, the above optional components. Viscosity (25°C) of the liquid photocurable resin composition thus obtained is preferably 10-20,000 cps, still more preferably 50-10,000 cps, and particularly preferably 50-5,000 cps.

The photocurable resin composition of the present invention thus obtained is suitably used as a liquid photocurable resin composition for the three-dimensional photofabrication method. Specifically, a three-dimensional product with a desired shape can be manufactured by using the three-dimensional photofabrication method in which energy required for curing is supplied to the liquid photocurable resin composition of the present invention by selectively applying light such as visible light, ultraviolet light, or infrared light to the liquid photocurable resin composition. A general description of the method known in the art is:
(1) coating a layer of a composition onto a surface, wherein the composition is used as defined in anyone of claims 1-20;
(2) exposing the layer imagewise to actinic radiation to form an imaged cross-section, wherein the radiation is of sufficient intensity to cause substantial curing of the layer in the exposed areas;
(3) coating a layer of the composition onto the previously exposed imaged cross-section;
(4) exposing said thin layer from step (3) imagewise to actinic radiation to form an additional imaged cross-section, wherein the radiation is of sufficient intensity to cause substantial curing of the thin layer in the exposed areas and to cause adhesion to the previously exposed imaged cross-section;
(5) repeating steps (3) and (4) a sufficient number of times in order to build up the three-dimensional article.

As means for selectively applying light to the liquid photocurable resin composition, various means may be employed without specific limitations. For example, means for applying light to the composition while scanning with laser beams or focused rays converged by a lens, mirror, or the like, means for applying unfocused rays to the composition via a mask having a phototransmission area with a specific pattern, means for applying light to the composition via an optical fiber corresponding to a specific pattern of a photoconductive material formed by bundling optical fibers, or the like may be employed. In the case of employing the means using a mask, a mask which electro-optically forms a mask image comprising a phototransmission area and a non-phototransmission area according to a specific pattern by using the same principle as that of the liquid crystal display may be used. In the case where the target three-dimensional product is a product having a minute section or a product for which high dimensional accuracy is required, means for scanning with laser beams with a small spot diameter is preferably employed as the means for selectively applying light to the composition. The irradiation surface of the resin composition placed in a vessel (for example, scanning plane of focused rays) may be a liquid surface of the resin composition or the contact surface between the resin composition and the wall of a transparent vessel. In the case where light is applied to the liquid surface of the resin composition or the contact surface with the wall of the vessel, light may be applied to the composition either directly from outside of the vessel or indirectly through the wall of the vessel.

In the three-dimensional photofabrication method, after curing a predetermined area of the resin composition, the irradiation position (irradiation surface) is continuously or gradually moved from the cured area to the uncured area to layer the cured areas, whereby a desired three-dimensional shape is obtained. The irradiation position may be moved by moving the light source, the vessel of the resin composition, or the cured area of the resin composition, or by additionally providing the resin composition to the vessel. The resulting three-dimensional product is then removed from the vessel. After the residual unreacted resin composition remaining on the surface is removed, the three-dimensional product is optionally washed. As washing agents, alcohol-type organic solvents such as isopropyl alcohol and ethyl alcohol, ketone-type organic solvents such as acetone, ethyl acetate, and methyl ethyl ketone, aliphatic organic solvents such as terpenes, and low-viscosity heat curable or photo curable resins can be given. When fabricating a three-dimensional product having surface smoothness, it is preferable to wash the surface of the three-dimensional product using a heat curable or photo curable resin. In this case, postcuring by irradiation with heat or light is required in accordance with the types of curable resins used for washing. Since not only the resins on the surface of the object but also the uncured resin composition remaining inside the three-dimensional products can be cured by the postcure process, it is also preferable to perform the postcure process after washing with organic solvents.

The three-dimensional product thus obtained exhibits excellent initial strength after photofabrication, has high dimensional accuracy, excels in mechanical and thermal properties, and has particularly excellent fracture toughness. In order to improve surface hardness and heat resistance of the three-dimensional product, it may be preferable to coat the surface of the three-dimensional product with a heat curable or photo curable hard coating material after the washing treatment. As the hard coating material, an organic coating material such as an acrylic resin, epoxy resin, and silicone resin, or an inorganic hard coating material may be used. The hard coating material may be used either individually or in combination of two or more.

The photofabricated product obtained in the present invention may be further subjected to a heat treatment at usually 40-200°C, preferably 60-150°C, and still more preferably 80-120°C in order to further improve heat resistance and fracture toughness and to obtain desired characteristics in a short period of time. In this case, if the heat treatment temperature is 200°C or more, thermal deformation of the photofabricated product occurs, whereby dimensional accuracy cannot be obtained.

### Examples

The present invention is described below in more detail by way of examples. However, the following examples should not be construed as limiting the present invention.

### Examples 1-4 and Comparative Examples 1-5

A reaction vessel equipped with a stirrer was charged with the components shown in Table 1. The mixture was stirred at 60°C for three hours to prepare a liquid composition. The amount of the components in Table 1 is indicated by part by weight.

**[Table 1 ]**

| Component | | | Example | | | | Comparative Example | | | | |
|---|---|---|---|---|---|---|---|---|---|---|---|
| | | | 1 | 2 | 3 | 4 | 1 | 2 | 3 | 4 | 5 |
| 1 | A | 3,4-Epoxycyclohexylmethyl-3',4'-epoxycyclohexylcarboxylate, | 30 | 30 | 30 | 30 | 30 | 30 | 30 | 30 | 30 |
| 2 | A | Bis(3,4-epoxycyclohexylmethyl)adipate | 20 | 20 | 20 | 20 | 20 | 20 | 20 | 20 | 20 |
| 3 | A | Bisphenol A diglycidyl ether | 15 | 0 | 10 | 15 | 30 | 15 | 15 | 0 | 15 |
| 4 | F | Elastomer particles | 6 | 6 | 6 | 6 | 6 | 6 | 6 | 6 | 6 |
| 5 | G | PO modified trimethylolpropane | 10 | 10 | 10 | 10 | 10 | 10 | 10 | 10 | 10 |
| 6 | E | Dipentaerythritol hexaacrylate | | | 5 | | | 15 | | 30 | 15 |
| 7 | E | Trimethylolpropane triacrylate | | | | | | | 15 | | |
| 8 | C | Tris(acryloyloxyethyl)isocyanurate | 15 | 30 | 15 | | | | | | 3 |
| 9 | C | Bis(acryloyloxyethyl)hydroxyethyl isocyanurate | | | | 15 | | | | | |
| 10 | B | Triarylsulfonium hexafluoroantimonate | 2 | 2 | 2 | 2 | 2 | 2 | 2 | 2 | 2 |
| 11 | D | 1-hydroxycyclohexyl phenyl ketone | 2 | 2 | 2 | 2 | 2 | 2 | 2 | 2 | 2 |
| | | Total | 100 | 100 | 100 | 100 | 100 | 100 | 100 | 100 | 100 |
| Evaluation | | | | | | | | | | | |
| 1 | | Viscosity (MPa·s) | 600 | 800 | 650 | 550 | 700 | 500 | 450 | 900 | 750 |
| 2 | | Bending test (number of times) | 60 | 70 | 55 | 58 | 23 | 20 | 17 | 25 | 25 |
| 3 | | Fracture toughness value (MPa·m^{1/2}) | 4.5 | 4.5 | 4.0 | 4.3 | Could not be measured | 2.0 | 2.0 | 1.5 | 2.1 |
| 4 | | HDT | 85 | 90 | 85 | 85 | Could not be measured | 85 | 85 | 90 | 65 |
| 5 | | Warping | Excellent | Excellent | Excellent | Excellent | Could not be measured | Good | Good | Bad | Good |
| 6 | | Green strength (mm) | Good | Excellent | Excellent | Good | Bad | Good | Good | Excellent | Good |

| | | | | | | | | | | | |
|---|---|---|---|---|---|---|---|---|---|---|---|
| 1) UVR-6110 (manufactured by Union Carbide Corp.) 2) UVR-6199 (manufactured by Union Carbide Corp.) 3) Epikote 828 (manufactured by Japan Epoxy Resins Co., Ltd.) 4) Reginous Bond RKB (manufactured by Reginous Chemical Industries Co., Ltd.) 5) Sunnix GP-400 (manufactured by Sanyo Chemical Industries, Ltd.) 6) DPHA (manufactured by Nippon Kayaku Co., Ltd.) 7) TMPTA (manufactured by Osaka Organic Chemical Industry Co., Ltd.) 8) M-315 (manufactured by Toagosei Co., Ltd.) 9) M-215 (manufactured by Toagosei Co., Ltd.) 10) UVI6974 (manufactured by Dow Chemical) 11) Irgacure 184 (manufactured by Ciba Specialty Chemicals Co., Ltd.) | | | | | | | | | | | |

### Test Example

### Measurement of viscosity

### (1) Measurement

The viscosity of the liquid resin was measured at 25°C using a BM-type viscometer manufactured by Toyo Seiki Seisaku-Sho, Ltd.

### Bending test

### (1) Preparation of test specimen

The liquid resin was applied to a glass plate to a thickness of 200 µm. Light was applied to the liquid resin at a dose of 500 mJ/cm² using a high-pressure mercury lamp to obtain a cured film. The measurement was conducted after allowing the cured film to stand in a thermo-hygrostat at a temperature of 23°C and a humidity of 50% for 24 hours.

### (2) Measurement

A test specimen with a dimension of 12 x 3 cm was cut from the cured film thus prepared. The number of times the test specimen was bent until the test specimen broke was measured using an MIT bending tester. The measurement was performed at an initial load of 200 g.

### Fracture toughness test

### (1) Preparation of test specimen

Laser light was selectively applied to the photocurable resin composition at a laser power of 100 mW at the irradiation surface (liquid surface) and a scanning speed at which the cure depth of each composition was 0.3 mm using a solid creator "SCS-300P" (manufactured by Sony Manufacturing Systems, Inc.) to form a cured resin layer (thickness: 0.20 mm). This step was repeated to fabricate a test specimen (length: 60 mm, width: 10 mm, thickness: 5 mm) according to the SENB method specified in the ASTM E 399-83 standard. The test specimen was removed from the solid creator. The resin composition adhering to the outer surface of the test specimen was removed by washing. The measurement was conducted after allowing the test specimen to stand in a thermo-hygrostat at a temperature of 23°C and a humidity of 50% for 24 hours.

### (2) Measurement

A V-shaped notch with a depth of 5 mm was formed at the center of the test specimen thus prepared in the direction of the width of the test specimen. The fracture toughness value was measured by using a model 5567 manufactured by Instron according to the SENB method specified in the ASTM E 399-83 standard. The distance between the support points was 40 mm.

### Heat deflection temperature (HDT)

### (1) Preparation of test specimen

A test specimen (length: 120 mm, width: 10 mm, thickness: 4 mm) according to the flat-wise method specified in the JIS K7191 standard was fabricated using the above-described method. The test specimen was removed from the solid creator. The resin composition adhering to the outer surface of the test specimen was removed by washing. The measurement was conducted after allowing the test specimen to stand in a thermo-hygrostat at a temperature of 23°C and a humidity of 50% for 24 hours.

### (2) Measurement

The HDT of the test specimen thus prepared was measured by using a heat distortion tester manufactured by Yasuda Seiki Seisakusho, Ltd. according to the flat-wise method (b) specified in the JIS K7191 standard. The measurement load was 0.45 MPa.

### Measurement of warping

### (1) Preparation of test specimen

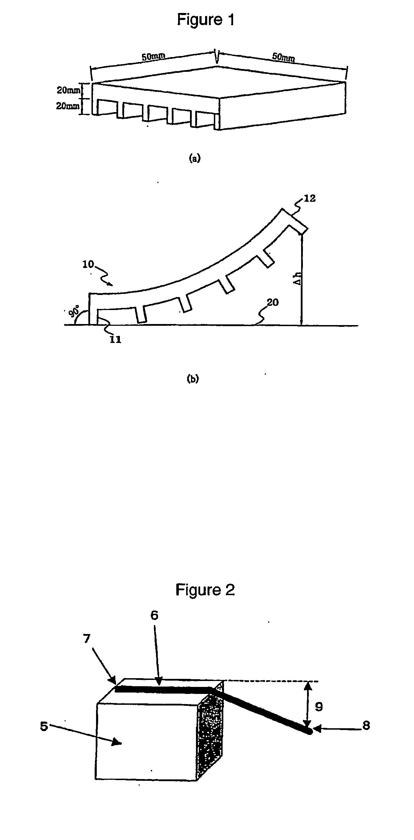

A test specimen shown in FIG. 1 (a) (hereinafter called "warping model 10") was fabricated according to the above-described method. The test specimen was removed from the solid creator. The resin composition adhering to the outer surface of the test specimen was removed by washing. The measurement was conducted after allowing the test specimen to stand in a thermo-hygrostat at a temperature of 23°C and a humidity of 50% for 24 hours.

### (2) Measurement

A leg 11 of a warping model 10 was secured to a horizontal stand 20 as shown in FIG. 1 (b). The distance Δh between the horizontal stand 20 and the bottom end of the leg 12 was evaluated as the amount of warping. The test specimen was rated as "excellent", "good", or "bad" corresponding to the amount of warping.

### Measurement of green strength

### (1) Preparation of test specimen

A cured line with a length of 3 cm was formed by using SCS-300P at a laser power of 100 mW at the irradiation surface (liquid surface), a scanning speed of 300 mm/sec, and a dose of about 170 mJ/cm² when the curing width was 200 wm.

### (2) Measurement

A cured line 6 thus obtained was secured to a horizontally placed block 5 (length: 15 mm, width: 15 mm, height 15 mm) shown in FIG. 2 at one end 7 so that the other end 8 projected from the end face of the block 5 to a distance of 15 mm. The distance 9 between the end 8 and the upper surface of the block 5 was evaluated as the green strength. In the case where the distance 9 was 10 mm or more, the green strength was evaluated as "bad". In the case where the distance 9 was 5 cm or more but less than 10 mm, the green strength was evaluated as "fair". In the case where the distance 9 was 3 cm or more but less than 5 mm, the green strength was evaluated as "good". In the case where the distance 9 was less than 3 cm, the green strength was evaluated as "excellent'.
The results are shown in Table 1.

As is clear from Examples 1-4 in Table 1, the cured film including the polyfunctional acrylic monomer component 8 or 9 having the structure shown by the formula (1) had excellent bending resistance and high fracture toughness value in comparison with the cured film containing the polyfunctional acrylic monomer component 6 or 7 which does not have the structure shown by the formula (1) in Comparative Examples 2-4. Specifically, toughness was significantly improved. The composition of Examples 1-4 had viscosity of 1000 cps or less. Therefore, when supplying the liquid photocurable resin composition for one layer during fabrication, a liquid layer with a uniform thickness can be formed. From comparison between Example 1 and Example 4, the component 9 which is the bifunctional component (C) provides a cured product having performance equal to the component 8 which is the trifunctional component (C). In the case of improving green strength by using 30 parts by weight of the component 6 (Comparative Example 4), the amount of warping was significantly increased and the fracture toughness value was significantly decreased. On the contrary, the component 8 allows green strength to be improved while maintaining the amount of warping and the fracture toughness value, even if the component 8 is used in an amount of 30 parts by weight. However, if the amount of the component (C) in the total amount of the components (C) and (E) is less than 50 wt% as shown in Comparative Example 5, a sufficient improvement effect of toughness cannot be obtained. In the case of using the resin composition which does not include the acrylic component as in Comparative Example 1, photocurability was significantly decreased and a product could not be fabricated. The resin compositions of Examples 1-4 which include the component 6 in an amount of 5 wt% or more of the total amount of the composition showed an HDT of 80°C or more, and exhibited excellent heat resistance equal to that of Comparative Examples 1-4. These effects originate in the isocyanurate cyclic structure shown by the formula (1). As is clear from the above results, a photofabricated three-dimensional product formed of the composition of the present invention has excellent photocurability and heat resistance and shows high initial strength, low warping, and high toughness. Moreover, since the viscosity of the liquid resin is low, the three-dimensional product is useful as prototype or evaluation parts for which high accuracy and toughness are required.

### Brief Description of the Drawings

### Figure 1

FIG. 1 is an explanatory diagram showing an outline of the shape of a measurement model and a measurement method for the amount of deformation with time of cured products of photocurable compositions prepared in examples and comparative examples.

### Figure 2

FIG. 2 is an explanatory diagram showing an outline of the shape of a measurement model and a measurement method for initial strength (green strength) of cured products of photocurable compositions after photofabrication.

### Explanation of Symbols

5: Block
6: Cured line
7: End
8: End
9: Distance between end and upper surface of block 5
10: Warping model
11, 12: Leg
20: Horizontal stand

## Claims

1. A photocurable resin composition comprising:
(A) 30-85 wt% of a cationically polymerizable component,
(B) 0.1-10 wt% of a cationic-polymerization initiator,
(C) 5-45 wt% of a component having a structure shown by the following formula (1), 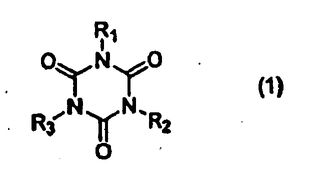 wherein R¹, R², and R³ individually represent organic groups, provided that at least two of R¹, R², and R³ have a polymerizable carbon-carbon double bond,
(D) 0.1-10 wt% of a radical-polymerization initiator, and
(E) 0-20 wt% of a component having at least one radically polymerizable group in the molecule, and wherein component A is selected from the group consisting of 3,4-epoxycyclohexylmethyl-3',4'-epoxycyclohexanecarboxylate, bis(3,4-epoxycyclohexylmethyl)adipate, ε-caprolactone-modified 3,4-epoxycyclohexylmethyl-3',4'-epoxycyclohexanecarboxylate, trimethylcaprolactone-modified 3,4-epoxycyclohexylmethyl-3',4'-epoxycyclohexanecarboxylate, p-methyl-δ-valerolactone-modified 3,4-epoxycyclohexylmethyl-3',4'-epoxycyclohexanecarboxylate, bisphenol A diglycidyl ether, bisphenol F diglycidyl ether, hydrogenated bisphenol A diglycidyl ether, hydrogenated bisphenol F diglycidyl ether, 1,4-butanediol diglycidyl ether, 1,6-hexanediol diglycidyl ether, trimethylolpropane triglycidyl ether, glycerol triglycidyl ether, polyethylene glycol diglycidyl ether and polypropylene glycol diglycidyl ether.

2. The composition according to claim 1, wherein the component (C) contains a spacer molecule between the carbon-carbon double bond and the isocyanurate cyclic structure.

3. The composition according to claim 2, wherein the spacer molecule is an aliphatic chain by modifying the isocyanurate cyclic structure with ethylene oxide, propylene oxide, or ε-caprolactone.

4. The composition according to anyone of claims 1 to 3, wherein component (C) is selected from the group consisting of bis((meth)(acryloxymethyl)hydroxymethyl isocyanurate, bis((meth)acryloxyethyl)hydroxyethyl isocyanurate, tris((meth)acryloxymethyl)isocyanurate, tris((meth)acryloxyethyl)isocyanurate and caprolactone-modified tris((meth)acryloxyethyl)isocyanurate.

5. The composition according to anyone of claims 1 to 4, wherein the component (C) is used in an amount of 10-35 wt%.

6. The composition according to anyone of claims 1 to 5, wherein a polyfunctional acrylate is present selected from the group consisting of trimethylolpropane tri(meth)acrylate, EO-modified trimethylolpropane tri(meth)acrylate, dipentaerythritol hexa(meth)acrylate, dipentaerythritol penta(meth)acrylate, and ditrimethylolpropane tetra(meth)acrylate.

7. The composition according to anyone of claims 1 to 6, wherein composition comprises (F) elastomer particles with an average particle diameter of 10-1000 nm.

8. A process for forming a three-dimensional article comprising:
(1) coating a layer of a composition onto a surface, wherein the composition is used as defined in anyone of claims 1-7;
(2) exposing the layer imagewise to actinic radiation to form an imaged cross-section, wherein the radiation is of sufficient intensity to cause substantial curing of the layer in the exposed areas;
(3) coating a layer of the composition onto the previously exposed imaged cross-section;
(4) exposing said thin layer from step (3) imagewise to actinic radiation to form an additional imaged cross-section, wherein the radiation is of sufficient intensity to cause substantial curing of the thin layer in the exposed areas and to cause adhesion to the previously exposed imaged cross-section;
(5) repeating steps (3) and (4) a sufficient number of times in order to build up the three-dimensional article.

9. Use of a composition as defined in anyone of claims 1-7, for making three dimensional objects.

10. A three dimensional object made from a composition as defined in anyone of claims 1-7 by curing the composition.

## Patentansprüche

1. Photohärtbare Harzzusammensetzung, umfassend:
(A) 30-85 Gew.-% einer kationisch polymerisierbaren Komponente;
(B) 0,1-10 Gew.-% eines kationischen Polymerisationsstarters;
(C) 5-45 Gew.-% einer Komponente mit einer Struktur, die durch die folgende Formel (1) 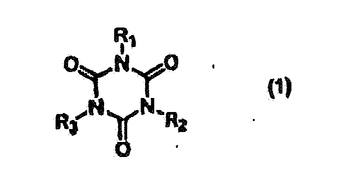 dargestellt ist, wobei R¹, R² und R³ unabhängig für organische Gruppen stehen, mit der Maßgabe, dass wenigstens zwei von R¹, R² und R³ eine polymerisierbare Kohlenstoff-Kohlenstoff-Doppelbindung aufweisen;
(D) 0,10-10 Gew.-% eines radikalischen Polymerisationsstarters;
(E) 0-20 Gew.-% einer Komponente mit wenigstens einer radikalisch polymerisierbaren Gruppe im Molekül;
wobei Komponente A aus der Gruppe ausgewählt ist, die aus 3,4-Epoxycyclohexylmethyl-3',4'-epoxycyclohexancarboxylat, Bis(3,4-epoxycyclohexylmethyl)adipat, ε-Caprolacton-modifiziertem 3,4-Epoxycyclohexylmethyl-3',4'-epoxycyclohexancarboxylat, Trimethylcaprolacton-modifiziertem 3,4-Epoxycyclohexylmethyl-3',4'-epoxycyclohexancarboxylat, β-Methyl-δ-valerolacton-modifiziertem 3,4-Epoxycyclohexylmethyl-3',4'-epoxy-cyclohexancarboxylat, Bisphenol-A-diglycidylether, Bisphenol-F-diglycidylether, hydriertem Bisphenol-A-diglycidylether, hydriertem Bisphenol-F-diglycidylether, 1,4-Butandioldiglycidylether, 1,6-Hexandioldiglycidylether, Trimethylolpropantriglycidylether, Glycerintriglycidylether, Polyethylenglycoldiglycidylether und Polypropylenglycoldiglycidylether besteht.

2. Zusammensetzung gemäß Anspruch 1, wobei die Komponente (C) ein Spacermolekül zwischen der Kohlenstoff-Kohlenstoff-Doppelbindung und der cyclischen Isocyanuratstruktur enthält.

3. Zusammensetzung gemäß Anspruch 2, wobei das Spacermolekül eine aliphatische Kette ist, die entsteht, indem man die cyclische Isocyanuratstruktur mit Ethylenoxid, Propylenoxid oder ε-Caprolacton modifiziert.

4. Zusammensetzung gemäß einem der Ansprüche 1 bis 3, wobei Komponente (C) aus der Gruppe ausgewählt ist, die aus Bis((meth)(acryloxy-methyl)hydroxymethylisocyanurat, Bis((meth)acryloxyethyl)hydroxyethyl-isocyanurat, Tris((meth)acryloxymethyl)isocyanurat, Tris((meth)acryloxy-ethyl)isocyanurat und Caprolacton-modifiziertem Tris((meth)acryloxy-ethyl)isocyanurat besteht.

5. Zusammensetzung gemäß einem der Ansprüche 1 bis 4, wobei die Komponente (C) in einer Menge von 10-35 Gew.-% verwendet wird.

6. Zusammensetzung gemäß einem der Ansprüche 1 bis 5, wobei ein polyfunktionelles Acrylat vorhanden ist, das aus der Gruppe ausgewählt ist, die aus Trimethylolpropantri(meth)acrylat, EO-modifiziertem Trimethylol-propantri(meth)acrylat, Dipentaerythrithexa(meth)acrylat, Dipentaery-thritpenta(meth)acrylat und Ditrimethylolpropantetra(meth)acrylat besteht.

7. Zusammensetzung gemäß einem der Ansprüche 1 bis 6, wobei die Zusammensetzung (F) Elastomerteilchen mit einem mittleren Teilchendurchmesser von 10-1000 nm umfasst.

8. Verfahren zur Bildung eines dreidimensionalen Artikels, umfassend:
(1) Auftragen einer Schicht einer Zusammensetzung auf eine Oberfläche, wobei die Zusammensetzung verwendet wird, wie sie in einem der Ansprüche 1 bis 7 definiert ist;
(2) bildartiges Bestrahlen der Schicht mit aktinischer Strahlung unter Bildung eines bildartigen Querschnitts, wobei die Strahlung ausreichende Intensität hat, um eine weitgehende Härtung der Schicht in den bestrahlten Bereichen zu bewirken;
(3) Auftragen einer Schicht der Zusammensetzung auf den zuvor bestrahlten bildartigen Querschnitt;
(4) bildartiges Bestrahlen der dünnen Schicht aus Schritt (3) mit aktinischer Strahlung unter Bildung eines weiteren bildartigen Querschnitts, wobei die Strahlung ausreichende Intensität hat, um eine weitgehende Härtung der dünnen Schicht in den bestrahlten Bereichen und eine Anhaftung an dem zuvor bestrahlten bildartigen Querschnitt zu bewirken;
(5) Wiederholen der Schritte (3) und (4), bis der dreidimensionale Artikel fertig aufgebaut ist.

9. Verwendung einer Zusammensetzung gemäß einem der Ansprüche 1 bis 7 zur Herstellung von dreidimensionalen Objekten.

10. Dreidimensionales Objekt, das aus einer Zusammensetzung gemäß einem der Ansprüche 1 bis 7 durch Härten der Zusammensetzung hergestellt ist.

## Revendications

1. Composition de résine photodurcissable comprenant :
(A) 30-85 % en masse d'un composant polymérisable cationiquement,
(B) 0,1-10 % en masse d'un initiateur de polymérisation cationique,
(C) 5-45 % en masse d'un composant ayant une structure montrée par la formule (1) suivante 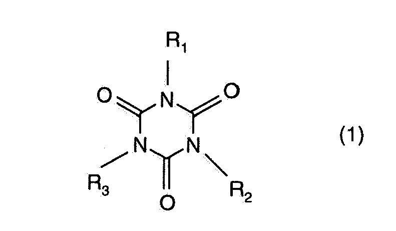 où R¹, R² et R³ représentent individuellement des groupes organiques, à condition qu'au moins deux de R¹, R² et R³ aient une double liaison carbone-carbone polymérisable,
(D) 0,1-10 % en masse d'un initiateur de polymérisation radicalaire, et
(E) 0-20 % en masse d'un composant ayant au moins un groupe polymérisable par polymérisation radicalaire dans la molécule, et où le composant (A) est choisi dans le groupe consistant en le 3',4'-époxycyclohexanecarboxylate de 3,4-époxycyclohexyl méthyle, l'adipate de bis-(3_{;}4-époxycyclohexytméthyle), le 3',4'-époxycyclohexanecarboxylate de 3,4-époxycyclohexyl méthyle modifié avec l'ε-caprolactone, le 3',4'-époxycyclohexanecarboxylate de 3,4-époxycyclohexylméthyle modifié avec la triméthylcaprolactone, le 3',4'-époxycyclohexanecarboxylate de 3,4-époxycyclohexylméthyle modifié avec la β-méthyl-δ-valérolactone, le diglycidyléther de bisphénol A, le diglycidyléther de bisphénol F, le diglycidyléther de bisphénol A hydrogéné, le diglycidyléther de bisphénol F hydrogéné, le diglycidyléther de 1,4-butanediol, le diglycidyléther de 1,6-hexanediol, le triglycidyléther de trimétylolpropane, le triglycidyléther de glycérol, le diglycidyléther de polyéthylèneglycol et le diglycidyléther de polypropylèneglycol.

2. Composition selon la revendication 1 où le composant (C) contient une molécule espaceur entre la double liaison carbone-carbone et la structure cyclique isocyanurate.

3. Composition selon la revendication 2 où la molécule espaceur est une chaîne aliphatique par modification de la structure cyclique isocyanurate avec l'oxyde d'éthylène, l'oxyde de propylène ou l'e-caprolactone.

4. Composition selon l'une quelconque des revendications 1 à 3 où le composant (C) est choisi dans le groupe consistant en l'isocyanurate de bis((méth)(acryloxyméthyl)hydroxyméthyle, l'isocyanurate de bis((méth)(acryloxyéthyl)hydroxyéthyle, l'isocyanurate de tris((méth)-acryloxyméthyle), l'isocyanurate de tris((méth)acryloxyéthyle) et l'isocyanurate de tris((méth)acryloxyéthyle) modifié avec la caprolactone.

5. Composition selon l'une quelconque des revendications 1 à 4 où le composant (C) est utilisé en une quantité de 10-35 % en masse.

6. Composition selon l'une quelconque des revendications 1 à 5 où un acrylate polyfonctionnel choisi dans le groupe consistant en le tri(méth)acrylate de triméthylolpropane, le tri(méth)acrylate de triméthylolpropane modifié avec OE, l'hexa(méth)acrylate de dipentaérythritol, le penta(méth)acrylate de dipentaérythritol et le tétra(méth)acrylate de ditriméthylolpropane est présent.

7. Composition selon l'une quelconque des revendications 1 à 6 où la composition comprend (F) des particules d'élastomère ayant un diamètre de particule moyen de 10 - 1 000 nm.

8. Procédé pour former un article tridimensionnel comprenant :
(1) l'application en revêtement d'une couche d'une composition sur une surface, où la composition est utilisée comme défini dans l'une quelconque des revendications 1-7 ;
(2) l'exposition de la couche selon une image à un rayonnement actinique pour former une section transversale munie d'une image, où le rayonnement est d'intensité suffisante pour provoquer un durcissement sensible de la couche dans les zones exposées ;
(3) l'application en revêtement d'une couche de composition sur la section transversale munie d'une image exposée auparavant ;
(4) l'exposition de ladite couche mince provenant de l'étape (3) selon une image à un rayonnement actinique pour former une section transversale munie d'une image supplémentaire, où le rayonnement est d'intensité suffisante pour provoquer un durcissement sensible de la couche mince dans les zones exposées et pour provoquer une adhésion à la section transversale munie d'une image exposée auparavant ;
(5) la répétition des étapes (3) et (4) un nombre de fois suffisant pour constituer l'article tridimensionnel.

9. Utilisation d'une composition selon l'une quelconque des revendications 1-7 pour produire des objets tridimensionnels.

10. Objet tridimensionnel produit à partir d'une composition selon l'une quelconque des revendications 1-7 par durcissement de la composition.
